Europäisches Patentamt

European Patent Office

Office européen des brevets

(11) Veröffentlichungsnummer: **0 207 946**
**B1**

(12) **EUROPÄISCHE PATENTSCHRIFT**

(45) Veröffentlichungstag der Patentschrift: **23.05.90**

(51) Int. Cl.⁵: **H 05 K 9/00**

(21) Anmeldenummer: **85903834.1**

(22) Anmeldetag: **27.07.85**

(86) Internationale Anmeldenummer:
**PCT/EP85/00378**

(87) Internationale Veröffentlichungsnummer:
**WO 86/01069 13.02.86 Gazette 86/04**

(54) **ELEKTROMAGNETISCHE ABSCHIRMVORRICHTUNG.**

(30) Priorität: **27.07.84 DE 3427706**

(43) Veröffentlichungstag der Anmeldung:
**14.01.87 Patentblatt 87/03**

(45) Bekanntmachung des Hinweises auf die
Patenterteilung:
**23.05.90 Patentblatt 90/21**

(84) Benannte Vertragsstaaten:
**AT CH DE FR GB IT LI LU NL SE**

(56) Entgegenhaltungen:
**DE-A-2 522 186
DE-A-3 210 843
DE-A-3 219 263
DE-B-1 190 521
GB-A-2 061 624
US-A-2 065 651
US-A-2 825 042**

(73) Patentinhaber: **ALCATEL N.V.
Strawinskylaan 537 (World Trade Center)
NL-1077 XX Amsterdam (NL)**
(84) **CH FR GB IT LI LU NL SE AT**

(73) Patentinhaber: **Standard Elektrik Lorenz
Aktiengesellschaft
Lorenzstrasse 10
D-7000 Stuttgart 40 (DE)**
(84) **DE**

(72) Erfinder: **REICHERT, Günther
verstorben (DE)**

(74) Vertreter: **Gähr, Hans-Dieter, Dipl.-Ing. (FH) et al
Standard Elektrik Lorenz AG Patent- und
Lizenzwesen Postfach 30 09 29
D-7000 Stuttgart 30 (DE)**

Courier Press, Leamington Spa, England.

# Beschreibung

Die Erfindung betrifft eine elektromagnetische Abschirmvorrichtung nach dem Oberbegriff des Anspruchs 1.

Aus der DE—PS 30 39 681 ist eine derartige Abschirmvorrichtung bekannt, die aus Federkontaktelementen besteht, die aus einem Blechstreifen freigeschnitten sind, der L-förmigen Querschnitt hat und in Nute von Gehäuseteilen einsetzbar ist. Das eine Gehäuseteil, z.B. ein Eckprofil, weist derartige, besonders geformte Nute auf, in die sowohl die Kontaktfederstreifen als auch die jeweils benachbarten Gehäuseteile (Verschlußplatten) eingeschoben sind. Durch die Kontakfederstreifen sind die Gehäuseteile elektrisch leitend verbunden und bilden zugleich eine elektromagnetische Abschirmung für das Gehäuseinnere. Die beschriebene Art der Abschirmvorrichtung eignet sich allerdings nur für fixierte Gehäuseteile also nicht für Türen oder ähnliche bewegliche Teile.

Zur elektromagnetischen Abdichtung von Turfugen ist 2 beispielsweise in der DE—PS 25 22 186 ein Dichtungselement beschrieben, das in der Tür angebracht ist. Bei dieser Konstruktion ist hinter einer abgewinkelten Türkante eine elastische Leiste befestigt. Zwischen dieser Leiste und einem parallel laufenden Winkelprofil ist die Lasche eines elektrisch leitenden Dichtungsstreifens eingeklemmt, der am freien Ende umgerollt ist und in diesem Teil mit einem elastischen Kern gefüllt sein kann. Beim Schließen der Tür wird der gerollte Teil gedrückt und stellt den Kontakt zwischen Tür und Gehäuse her.

Eine andere Abdichtung der Türfuge ist durch die DE—OS 32 19 263 bekannt, die allerdings nur für die Scharnierseite anwendbar ist. An dieser Seite ist das Türblatt wenigstens halbkreisförmig gebogen, wobei die Rundung von einem Federblech überdeckt wird, das einerseits mit der Tür, andererseits mit der Zarge verbunden ist.

Schließlich ist aus der DE—OS 32 10 843 eine Kontaktvorrichtung für gegeneinander bewegliche Gehäuseteile bekannt, bei der ein messerartiger Fortsatz des einen Gehäuseteiles in eine mit Kontaktfedern ausgekleidete Nut des anderer, Gehäuseteils eingreift.

Der Erfindung liegt die Aufgabe zugrunde, eine elektromagnetische Abschirmvorrichtung anzugeben, die einfach zu fertigen und zu montieren ist und für Fugen sowohl zwischen feststehenden als auch zwischen beweglichen Gehäuseteilen einsetzbar ist. Dabei soll eine gute Kontaktgabe gewährleistet sein, andererseits im Fall der Anbringung an einer Tür der Schließdruck nicht zu groß werden.

Gelöst wird diese Aufgabe durch die im Kennzeichen des Anspruchs 1 angegebenen Merkmale. Weiterbildungen sind den Unteransprüchen zu entnehmen. Die Vorteile dieser Lösung liegen darin, daß sie nicht nur die gestellten Forderungen erfüllt, sondern daß die Kontaktfedern auch ohne besondere Vorkehrungen an den Gehäuseteilen eingesetzt werden können, d.h. sie bedürfen weder der Führungsnute besonderer Profile noch zusätzlicher Befestigungsmittel. Ihr Sitz kann durch kleine Lappen verbessert werden, die in einfache Öffnungen eingreifen, was besonders bei beweglichen Teilen, wie Türen, von Nutzen ist.

Ausführungsbeispiele der Erfindung sind in der zugehörigen Zeichnung dargestellt und werden im folgenden näher beschrieben. Es zeigen:

Fig. 1 eine erfindungsgemäße Abschirmvorrichtung in Form einer Kontaktfeder, in perspektivischer Ansicht;

Fig. 2 eine Doppelkontaktfeder ähnlich der in Fig. 1 gezeigten, in perspektivischer Ansicht;

Fig. 3 eine auf eine Türkante aufgesetzte Kontaktfeder, im Querschnitt.

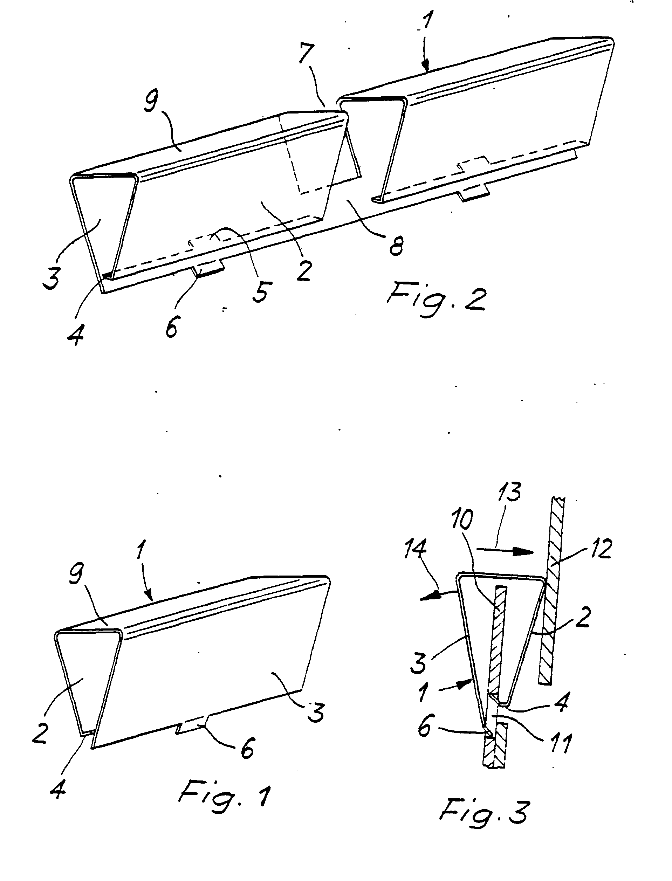

Die in den Figuren 1 bis 3 gezeigten Kontaktfedern 1 haben dreieckiges Profil, das ungefähr einem gleichschenkligen Dreieck entspricht. An einer Spitze ist das Dreieck offen, nämlich dort, wo die beiden, etwa gleichlangen Schenkel 2 und 3 einen spitzen Winkel einschließen. Der eine Schenkel 2 ist am freien Ende als schmale Lippe 4 nach innen abgebogen, die etwa parallel zum verbindenden, kurzen Schenkel 9 verläuft.

An den frei Enden der beiden Schenkel 2 und 3 ist mittig je ein Lappen 5 bzw. 6 angesetzt, der wiederum jeweils etwas nach innen gebogen ist.

Während in Fig. 1 eine einzelne Kontaktfeder 1 abgebildet ist, zeigt Fig. 2 eine doppelte, und zwar von der anderen Seite. Der Unterschied besteht lediglich darin, daß gewissermaßen zwei Kontaktfedern durch einen verbliebenen Steg 8 an einem der Schenkel verbunden sind. Die Teilung entsteht durch einen quer geführten Einschnitt 7 in das Profil Der Steg 8 liegt zweckmäßig im Kantenbereich des glatten Schenkels 3. Auf diese Weise kann die Kontaktfeder 1 auch am laufenden Band gefertigt und dann entsprechend den Erfordernissen durch Trennen des Steges in einzelne, doppelte oder mehrfache Kontaktfedern 1 geteilt werden. Hergestellt ist die Kontaktfeder 1 aus relativ dünnem Federblech, wie z.B. Federstahl, Federbronze usw. Sie zeichnet sich aus durch kleine Abmessungen, großen Federweg und geringen Druckanstieg über den gesamten Federweg. Ihr Kontaktwiderstand ist niederohmig.

Wie Fig. 3 verdeutlicht, wird die Kontaktfeder 1 einfach auf die Kante des Gehäuseteiles 10 aufgeschoben, wo sie durch die Lappen 5 und 6 in der Öffnung 11 selbstverriegelnd gehaltert ist. In der Ruhestellung liegt der Schenkel 3 am Gehäuseteil 10 an. Das mit 10 bezeichnete Teil ist eine Tür eines Schrankgehäuses oder einer Gestellverkleidung für elektronische Einrichtungen, die beim Schließen entsprechend Pfeil 13 gegen die Gehäusewand 12 schwenkt. Die Kontaktfeder 1 weicht dabei nach der anderen Seite gemäß Pfeil 14 aus. Durch die Kontaktfeder 1 erfolgt eine metallische Verbindung in den Gehäusefugen, so daß alle Gehäuse- bzw. Verkleidungsteile, wie Türen, Seitenwände usw., elektrisch leitend untereinander und mit den Gestellen verbunden, also auch geerdet sind. Zugleich kann ohne weiteres auch eine HF-dichte Schirmung erzielt

2

werden. Da die Anordnung der Kontaktfedern variabel ist, können die Abstände leicht den Frequenzen angepaßt werden, um jeweils eine vollständige Abschirmung des Gehäuses zu erreichen.

**Patentansprüche**

1. Elektromagnetische Abschirmvorrichtung in Form von Kontaktfederelementen für Fugen zwischen Gehäuse- oder Verkleidungsteilen von Schränken und Gestellen, die elektronische Einrichtungen enthalten, dadurch gekennzeichnet, daß die Kontaktfedern (1) dreieckiges, an einer Spitze offenes Profil haben und jeweils mit ihren freien Schenkeln (2, 3) über die Kante eines der beiden die Fuge bildenden Gehäuseteile (10) geschoben sind und mit einem Schenkel am anderen Gehäuseteil (12) anliegen.

2. Abschirmvorrichtung nach Anspruch 1, dadurch gekennzeichnet, daß der Querschnitt der Kontaktfeder (1) etwa dem eines gleichschenkligen Dreiecks entspricht.

3. Abschirmvorrichtung nach Anspruch 2, dadurch gekennzeichnet, daß das freie Ende des einen freien Schenkels (2) der Kontaktfeder (1) als schmale Lippe (4) nach innen abgebogen ist.

4. Abschirmvorrichtung nach Anspruch 3, dadurch gekennzeichnet daß an der Stirnseite beider freien Schenkel, (2, 3) je ein nach innen abgewinkelter Lappen (5, 6) angesetzt ist, und daß diese Lappen in eine Öffnung (11) des Gehäuseteiles (10) eingreifen.

5. Abschirmvorrichtung nach Anspruch 4, dadurch gekennzeichnet, daß die Kontaktfeder (1) durch wenigstens einen quer liegenden Einschnitt (7) so weit geteilt ist, daß nur in einem freien Schenkel (3) ein verbindender Steg (8) verbleibt.

**Revendications**

1. Dispositif constituant un écran contre les interférences électromagnétiques sous forme d'éléments de ressort de contact pour fermer des ouvertures ou des espacements entre des logements ou des parties de panneaux de fermeture de boîtiers et de baies contenant des dispositif électroniques, caractérisé en ce que les ressorts de contact (1) ont un profil triangulaire ouvert en un point et sont respectivement glissés avec leur branches libres (2, 3) sur le bord d'un des organes de logement (10) formant un espacement, et sont appliqués avec une branche contre l'autre organe de logement (12).

2. Dispositif écran comme sous 1, caractérisé en ce que la section du ressort de contact (1) correspond sensiblement à celle d'un triangle isoscèle.

3. Dispositif écran comme sous 2, caractérisé en ce que l'extrémité libre d'une des branche libres (2) du ressort de contact (1) est recourbée vers l'intérieur pour former une lèvre étroite (4).

4. Dispositif écran comme sous 3, caractérisé en ce que les faces d'extrémité des deux branches libres (2, 3) comprennent chacune une patte recourbée vers l'intérieur (5, 6), et que ces pattes s'engagent dans une ouverture (11) prévue dans l'organe de logement (10).

5. Dispositif écran comme sous 4, caractérisé en ce que le ressort de contact (1) est divisé partiellement par au moins une incision s'étendant transversalement (7), que seule une lame de connexion (8) demeure dans et des branches libres (3).

**Claims**

1. Electromagnetic interference shielding device in the form of contact spring elements for closing gaps or clearances between housing or covering-panel portions of cabinets and racks containing electronic devices, characterized in that the contact springs (1) have a triangular profile open at one point and are respectively slipped with their free legs (2, 3) over the edge of one of the two housing members (10) forming the gap and lie with one leg against the other housing member (12).

2. A shielding device as claimed in Claim 1, characterized in that the cross section of the contact spring (1) approximately corresponds to that of an isosceles triangle.

3. A shielding device as claimed in Claim 2, characterized in that the free end of the one free leg (2) of the contact spring (1) is bent inwards to form a narrow lip (4).

4. A shielding device as claimed in Claim 3, characterized in that the end faces of both free legs (2, 3) each comprise a bent-in flap (5, 6), and that these flaps engage in an aperture (11) provided in the housing member (10).

5. A shielding device as claimed in Claim 4, characterized in that the contact spring (1) is divided by at least one transversely extending incision (7) to such an extent that a connecting web (8) remains in only one of the free legs (3).

Fig. 2

Fig. 1

Fig. 3